# EUROPEAN PATENT APPLICATION

(11) **EP 0 847 076 A2**
(43) Date of publication of application: **10.06.1998**
(21) Application number: 97308883.4
(22) Date of filing: 05.11.1997
(51) Int. Cl.: H01L 21/00

(54) **Manufacturing semiconductor devices**

(30) Priority: 04.12.1996 GB 9625186
(71) Applicant: Smiths Industries Public Limited Company, London, NW11 8DS (GB)
(72) Inventor: Beardmore, Geoffrey, Cheltenham, Gloucestershire GL52 5DB (GB)
(74) Representative: Flint, Jonathan McNeill

(57) **Abstract**

A very compact silicon fabrication line has a number of process cells 20 to 25 all contained within a common outer enclosure 1. A semiconductor wafer 70 is loaded into the enclosure 1 through an air lock 10 and is mounted on a cap 56 supported under a carriage 80 movable along a rail 90 extending along the enclosure 1 between the different process cells 20 to 25. The cap 56 is lowered into sealing engagement with the open top 53, 54 of a cell 20 to 25 during each process.

## Description

This invention relates to apparatus of the kind for use in the manufacture of devices from a semiconductor wafer.

Current methods for manufacturing microengineered devices from semiconductor material, such as silicon, require dedicated buildings, clean rooms and support facilities. The cost of most silicon fabrication lines is between about $2M and $2000M.

It is an object of the present invention to provide an improved method and apparatus for manufacturing devices from silicon or the like.

According to one aspect of the present invention there is provided apparatus of the above-specified kind, characterised in that the apparatus includes an outer enclosure, a plurality of processing cells within the enclosure, a support for the wafer, and a transport system for moving the wafer between the cells such that a plurality of different processes can be carried out on the wafer within the enclosure.

The processing cells may include a cell for forming a pattern on a surface of the wafer and a cell for coating photo-resist onto the surface of the wafer. At least one of the cells is preferably hermetically sealed when the wafer is within the cell. The support for the wafer may make an hermetically sealing engagement with a part of the cell. The support for the wafer preferably includes a cap having a lower sealing surface arranged to engage around its edge an open top of a housing of the cell, the wafer being supported on the lower surface. The transport system may include a track, the support for the wafer including a carriage movable along the track. The enclosure may be sealed and have an air lock by which the wafer can be introduced into and removed from the enclosure.

According to another aspect of the present invention there is provided a method of manufacture of a device from a semiconductor material comprising the steps of introducing a wafer of the material into an enclosure, subjecting the wafer to a first process, moving the wafer within the enclosure, subjecting the wafer to a second process different from the first process and subsequently removing the wafer from the enclosure.

Apparatus for manufacturing devices from silicon and a method of carrying out the manufacture will now be described, by way of example, with reference to the accompanying drawings, in which:

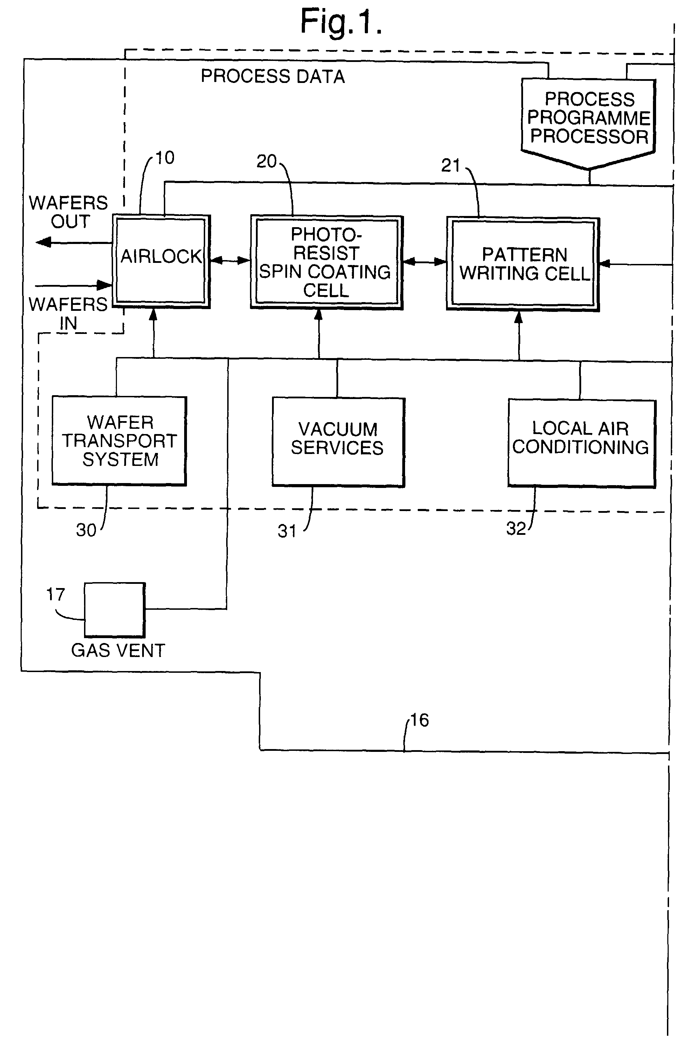

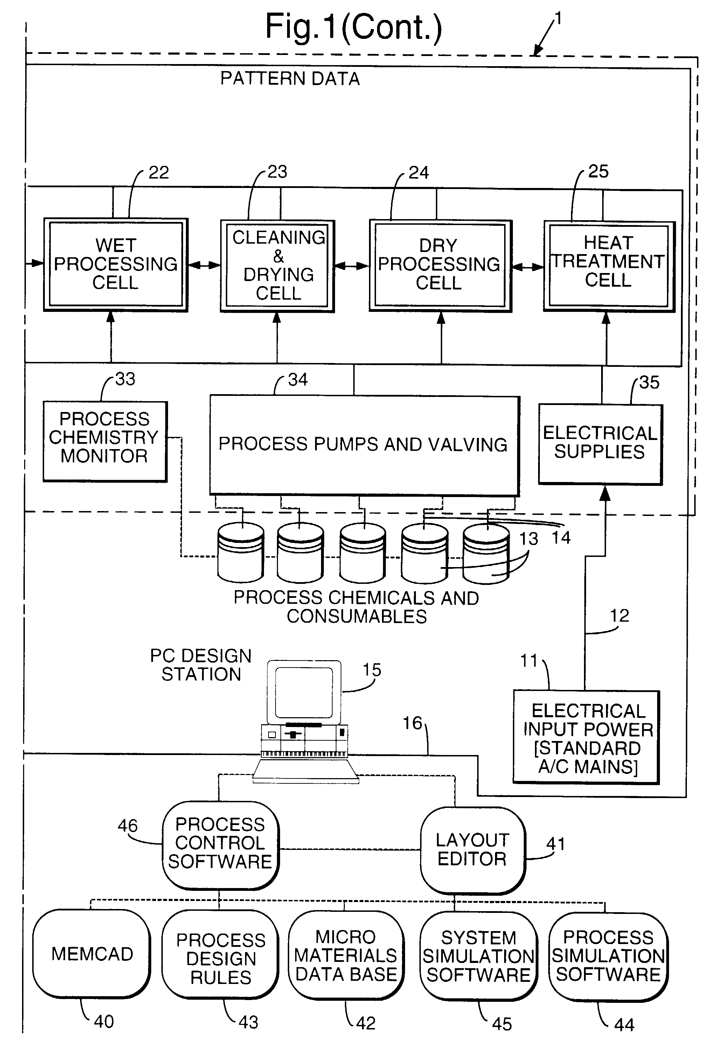

- Figure 1: is a schematic diagram of a layout of the apparatus; and
- Figure 2: is a cross-sectional side elevation of a cell in the apparatus.

The apparatus has an outer enclosure 1, which is typically a rectangular box about 2m long by 1m wide and 1.5m high. The enclosure 1 has an airlock 10 at one end and has connections to an electrical supply 11 via a cable 12, to process chemicals and consumables in vats 13 via pipes 14, to a PC design and control station 15 via two electrical databus 16, and to a gas vent 17.

The enclosure 1 contains six different processing or treatment cells 20 to 25 arranged in a straight line one after the other, although they could be arranged in different ways, such as in a circle. The cells are arranged in the following order.

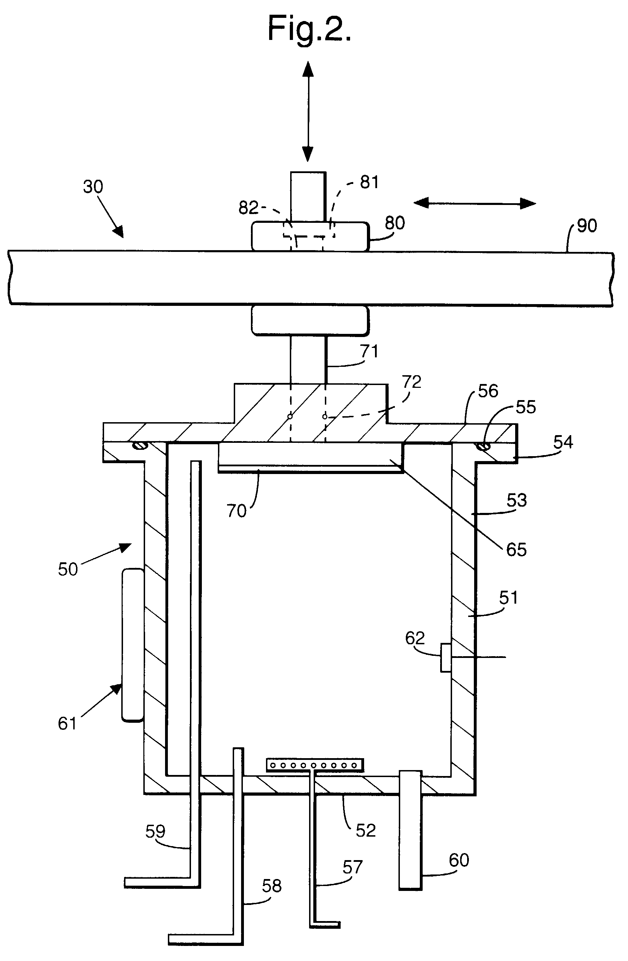

First, there is a photo-resist and spin coating cell 20 in which a wafer 70 (Figure 2) is supported upside down and a photo-resist liquid is applied by an upward jet to the lower surface of the silicon wafer. The cell 20 spins the wafer 20 about a vertical axis to distribute the resist evenly over its surface.

Second, is a pattern writing cell 21, which preferably includes a direct-write electron beam system operable to form an image on the layer of photo-resist.

Third, is a wet processing cell 22 where the layer of exposed resist is developed and fixed. The cell has provision for introducing and removing various chemicals. The chemicals can be agitated by continuously pumping the fluid. vibrating the wafer, bubbling inert gas through the solution or any combination of these techniques.

Fourth, is a cleaning and drying cell 23, which may be similar to the wet processing cell but has provision for applying a range of cleaning techniques such as solvents or water. Once cleaning is complete, the cell spins the wafer 70 in a jet of clean warm air or gas.

Fifth, is a dry processing cell 24, which may, for example, be a small vacuum deposition unit operable to coat a variety of different materials such as metals, oxides or the like. This may be by sputtering or evaporation from different targets. Reversing the process allows ion-etching to be carried out in the same cell. Reactive ion-etching may also be carried out with the introduction of a suitable gas.

Sixth, is a heat treatment cell 25 where the wafer 70 is heated for oxide film growth or other processes. Heat treatment can be carried out under vacuum, or in selected atmospheres. Boron diffusion and similar processes would normally use solid sources rather than a boron-rich atmosphere.

It will be appreciated that the apparatus may have different cells from those described. The wafer 70 may be moved back to a cell for an additional treatment, if necessary.

The apparatus also includes various service facilities. A wafer transport system is indicated generally by the block 30 - this transports the wafer 70 from the airlock 10 to each of the different cells 20 to 25 and then back to the airlock. The transport system 30 will be described in greater detail below. A vacuum services unit 31 is connected to those of the cells 20 to 25 required to operate at reduced pressure. A local air conditioning unit 32 is responsible for maintaining the temperature of the interior of the enclosure, outside the cells, and also has filters for ensuring low levels of contamination within the enclosure. A process chemistry monitor unit 33 monitors the levels of the process chemicals and consumables in the vats 13 and controls a process pumps and valving unit 34 by which the chemicals are supplied to the cells. An electrical supplies unit 35 distributes power to the different units and cells within the apparatus, monitors for electrical malfunction and effects a safe shut-down when a malfunction is detected. A process programme processor 36 receives data on lines 16 indicative of process data and of pattern data. The processor 36 appropriately controls operation of the different cells 20 to 25 and supplies the pattern writing cell 21 with the information to create the desired pattern or patterns on the wafer.

The PC design station 15 contains various software including a CAD (computer aided design) package 40 and a layout editor 41, which translates the overall design into a mask-level design. Separate software libraries allow access to a materials database 42, a process design rules database 43, process simulation 44, behaviour model creation and the like, as required. These are standard design tools available for microengineering design and can be updated when necessary without affecting the operation of the basic fabrication process. Additional specialist software 45, 46 is used to define the process sequence required to fabricate the desired structure. This is linked to the individual mask level files and controls the fabrication process once it has started. Definition of the process required for any given wafer could be done manually by the designer. Alternatively, it may incorporate some intelligent process definition based on the overall mechanical and electrical architecture in the design files. The entire design and processing sequence is stored in a series of software files, so intermediate glass/chrome masks are not required. This enables identical fabrication procedures to be repeated at any time, or previously generated designs can be processed at will. Multiple chip designs can be readily produced on a single wafer and individual elements of different designs can be combined at will.

With reference now to Figure 2, there is shown an example of a processing cell 50 and a part of the wafer transport system 30. The cell 50 comprises an outer cylindrical housing 51 of a material, such as glass, that will not react with the process chemicals used. The housing 51 is closed at its lower end 52 and is open at its upper end 53, having an outwardly projecting radial flange 54. The upper surface of the flange has an O-ring seal 55 extending around it, which makes a gas-tight seal with a cap assembly 56. The housing 51 has a gas inlet 57 and a process fill inlet 58 by which a liquid chemical can be admitted. A vent 59 opening at the upper end of the housing allows air to be expelled as the housing fills with the process gas or chemical. A drain or purge outlet 60 opens from the bottom of the housing 51 to allow removal of the process gas or liquid, after use. A temperature control unit 61 is mounted on the outer wall of the housing; this is used to raise, lower or maintain the temperature of the housing and its contents during processing. The housing also includes various process sensors. such as indicated at 62. These sensors 62 may include temperature, pressure and level sensors or the like.

The cap 56 forms a part of the wafer transport system 30 and is moved along the apparatus, with the wafer 70. The cap 56 has a flat lower surface, which makes a sealing contact with the O-ring seal 55 at the top of the housing 51. The cap 56 supports, on its lower side, a rotary platen 65, to the underside of which is secured the wafer 70, which is preferably 76mm or 100mm in diameter, but could be 127mm in diameter. The platen 65 is connected to a vertical shaft 71 projecting through a seal 72 in the cap 56. The upper end of the shaft 71 is mounted on a transport carriage 80 including a motor 81 coupled to the shaft 71 for rotating it and the platen 65 about a vertical axis. The carriage 80 also includes a solenoid 82 coupled to the shaft 71, for moving the shaft, and hence the cap 56, up or down along the vertical axis. In this way, the cap 56 can be lowered to seal with the top of the housing 51, or raised, so that the cap can be moved to a new cell. The carriage 80 is supported on a horizontal rail or track 90 extending along the apparatus above each of the cells. The carriage 80 may be moved along the track 90 in any conventional way. For example, the carriage 80 may be connected by a belt or chain to a fixed motor, or the carriage may carry a traction motor that engages the track to propel the carriage in the desired direction.

The silicon wafer 70 is initially loaded on the platen 65 in the air lock 10, which maintains cleanliness inside the apparatus and prevents the escape of residual processing chemicals. The wafer 70 is then transported into the apparatus from cell to cell so that the pattern is defined and material is removed, grown deposited or treated as desired, until the desired processing has been carried out on its lower surface. The carriage 80 then moves back to the air lock 10 so that the processed wafer 70 can be removed. If a double-sided wafer is required. the wafer 70 is turned over and replaced on the platen 65. It will be appreciated that the wafer 70 could easily be removed from the apparatus before completion of the process to enable inspection, testing or external processing. The wafer could then be reinserted to the apparatus

In this apparatus, the volume of each processing cell is kept to a minimum. This gives the apparatus an important advantage in enabling several cells to be contained within a common enclosure, obviating the need for a traditional clean room complex and greatly reducing the demand on supporting services. The fact that movement of the wafer between cells is mechanised is also an important advantage in enabling several cells to be contained within the same enclosure and thereby avoiding the need for housing the cells in conventional clean rooms. It will be appreciated that this greatly reduces the cost of providing a processing facility, especially where relatively low numbers of wafers need to be fabricated, such as for prototypes or small run, specialist devices.

It is possible for one cell to perform more than one processing function, thereby reducing the need to move the wafer between different cells. The apparatus is particularly suited to the fabrication of electro-mechanical fabrication, such as including bulk, dissolved water and mixed-mode processing and could include some surface machining capability. The apparatus may be used for the manufacture of devices of the kind described in, for example, GB2312314, WO97/18574, WO97/20189 and WO97/17616.

The present apparatus eliminates the need for a clean room and thereby eliminates the major source of possible contamination, which comes from the operator. Because the entire apparatus is sealed, it reduces the risk of exposure to and leakage of hazardous materials. Processing the wafer upside down has an advantage that gravity-borne detritus is less likely to contaminate the wafer, and processing solutions will rapidly drain away from the wafer surface once the cell is vented and purged. This can be encouraged by spinning the wafer and applying centrifugal force to any remaining droplets or particles on its surface.

## Claims

1. Apparatus for use in the manufacture of a device from a semiconductor wafer, characterised in that the apparatus includes an outer enclosure (1), a plurality of processing cells (20 to 25) within the enclosure, a support (56, 65, 80) for the wafer (70), and a transport system (30) for moving the wafer (70) between the cells (20 to 25) such that a plurality of different processes can be carried out on the wafer within the enclosure (1).

2. Apparatus according to Claim 1, characterised in that the processing cells include a cell (21) for forming a pattern on a surface of the wafer (70).

3. Apparatus according to Claim 2, characterised in that the cells include a cell (20) for coating photo- resist onto the surface of the wafer (70).

4. Apparatus according to any one of the preceding claims, characterised in that at least one of the cells (20 to 25) is hermetically sealed when the wafer (70) is within the cell.

5. Apparatus according to Claim 4, characterised in that the support (56) for the wafer (70) makes an hermetically sealing engagement with a part (53, 54, 55) of the cell (20 to 25).

6. Apparatus according to Claim 5, characterised in that the support (56, 65, 80) for the wafer (70) includes a cap (56) having a lower sealing surface arranged to engage around its edge an open top (53, 54, 55) of a housing (51) of the cell (20 to 25), and that the wafer (70) is supported on the lower surface.

7. Apparatus according to any one of the preceding claims, characterised in that the transport system (30) includes a track (90), and that the support for the wafer (70) includes a carriage (80) movable along the track.

8. Apparatus according to any one of the preceding claims, characterised in that the enclosure (1) is sealed and has an air lock (10) by which the wafer (70) can be introduced into and removed from the enclosure.

9. A method of manufacture of a device from a semiconductor material comprising the steps of introducing a wafer (70) of the material into an enclosure (1), subjecting the wafer to a first process, moving the wafer within the enclosure, subjecting the wafer to a second process different from the first process and subsequently removing the wafer (70) from the enclosure (1).
